# EUROPEAN PATENT APPLICATION

(11) **EP 4 692 822 A1**
(43) Date of publication of application: **11.02.2026**
(21) Application number: 24886059.5
(22) Date of filing: 11.10.2024
(51) Int. Cl.: G01R 31/392, G01R 31/396, G01R 31/367, G01R 31/382, G01R 19/12, G01R 19/30, G01R 19/165

(54) **APPARATUS AND METHOD FOR MANAGING BATTERY**

(30) Priority: 01.11.2023 KR 20230149458
(71) Applicant: LG Energy Solution, Ltd., Seoul 07335 (KR)
(72) Inventor: SUN, Kyung-Eun, Daejeon 34122 (KR); KWAK, Min, Daejeon 34122 (KR); BAE, Yoon-Jung, Daejeon 34122 (KR)
(74) Representative: Goddar, Heinz J.
(86) International application number: PCT/KR2024/015419
(87) International publication number: WO 2025/095384

(57) **Abstract**

A battery management apparatus according to an embodiment of the present disclosure includes a profile acquisition unit configured to acquire a differential profile indicating a correspondence relationship between voltage and differential capacity of a battery; and a control unit configured to determine a target peak from among a plurality of peaks included in the differential profile, determine the remaining peak except the target peak among the plurality of peaks as a reference peak, compare a differential capacity of the target peak with a differential capacity of the reference peak, determine a voltage of interest based on a result of the differential capacity comparison, and estimate a degree of degradation of the battery based on a capacity of interest of the battery corresponding to the voltage of interest.

## Description

### TECHNICAL FIELD

The present disclosure relates to a battery management apparatus and method, and more particularly, to a battery management apparatus and method for estimating the degree of battery degradation.

This application claims priority to Korean Patent Application No. 10-2023-0149458 filed on November 1, 2023 in the Republic of Korea, the disclosure of which is incorporated herein by reference.

### BACKGROUND

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that may be repeatedly charged and discharged.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging may be done whenever it is convenient, the self-discharge rate is very low and the energy density is high.

Because batteries degrade during operation, many studies are being made to estimate the condition and State of Health (SOH) of batteries more accurately during operation.

In general, the degree of battery degradation may be estimated through comparison between the criterion capacity and the current capacity based on the point in time when the battery is fully charged. However, when estimating the degree of battery degradation based on the point in time when the battery is fully charged, it is difficult to estimate the degree of battery degradation quickly because it takes time to fully charge the battery.

Meanwhile, a change in capacity of the battery in the corresponding voltage range may be calculated by integrating a differential profile with respect to voltage V, wherein the differential profile indicates a correspondence relationship between differential capacity dQ/dV and voltage V, and the differential capacity dQ/dV is a change of capacity Q as a function of voltage V in the battery. When the shapes of differential profiles of two batteries are similar in a specific voltage range, it may be thought that a change in capacity between the two batteries in the corresponding voltage range is also similar.

Therefore, when estimating the degree of battery degradation based on capacity of the battery, there is a need for development of technology for differently determining the voltage of interest used to estimate the degree of degradation according to the shape of the differential profile.

### DISCLOSURE

### Technical Problem

The present disclosure is designed to solve the above-described problem, and therefore the present disclosure is directed to providing a battery management apparatus and method for estimating the degree of battery degradation based on a capacity of interest corresponding to each voltage of interest by differently determining the voltage of interest according to the shape of a differential profile.

These and other objectives and advantages of the present disclosure may be understood from the following description and will become apparent from the embodiments of the present disclosure. Also, it will be easily understood that the objectives and advantages of the present disclosure may be realized by the means set forth in the appended claims and a combination thereof.

### Technical Solution

A battery management apparatus according to an aspect of the present disclosure may include a profile acquisition unit configured to acquire a differential profile indicating a correspondence relationship between voltage and differential capacity of a battery; and a control unit configured to determine a target peak from among a plurality of peaks included in the differential profile, determine the remaining peak except the target peak among the plurality of peaks as a reference peak, compare a differential capacity of the target peak with a differential capacity of the reference peak, determine a voltage of interest based on a result of the differential capacity comparison, and estimate a degree of degradation of the battery based on a capacity of interest of the battery corresponding to the voltage of interest.

The control unit may be configured to determine the peak having highest corresponding voltage among the plurality of peaks as the target peak.

The control unit may be configured to determine a preset criterion voltage as the voltage of interest when the differential capacity of the target peak exceeds the differential capacity of the reference peak.

The criterion voltage may be preset as a voltage of a criterion minimum point having highest corresponding voltage among a plurality of minimum points included in a preset criterion differential profile corresponding to the battery.

The criterion minimum point may be preset as a minimum point having highest corresponding voltage on a low voltage side of a criterion peak corresponding to the target peak.

The criterion voltage may be preset as a voltage of a criterion peak corresponding to the target peak among the plurality of peaks included in the criterion differential profile.

The control unit may be configured to determine an end-of-charge voltage of the battery as the voltage of interest when the differential capacity of the target peak is equal to or less than the differential capacity of the reference peak.

The control unit may be configured to estimate a difference between a preset criterion capacity and the capacity of interest as the degree of degradation of the battery.

The control unit may be configured to estimate a ratio of the capacity of interest to a preset criterion capacity as the degree of degradation of the battery.

The criterion capacity may be a preset capacity corresponding to the voltage of interest.

The control unit may be configured to set usage conditions of the battery based on the estimated degree of degradation of the battery.

A battery pack according to another aspect of the present disclosure may include the battery management apparatus according to an aspect of the present disclosure.

A vehicle according to still another aspect of the present disclosure may include the battery management apparatus according to an aspect of the present disclosure.

A battery management method according to yet another aspect of the present disclosure may include a profile acquisition step of acquiring a differential profile indicating a correspondence relationship between voltage and differential capacity of a battery; a peak determination step of determining a target peak from among a plurality of peaks included in the differential profile, and determining the remaining peak except the target peak among the plurality of peaks as a reference peak; a comparison step of comparing a differential capacity of the target peak with a differential capacity of the reference peak; a voltage determination step of determining a voltage of interest based on a result of the differential capacity comparison; and a degree of degradation estimation step of estimating a degree of degradation of the battery based on a capacity of interest of the battery corresponding to the voltage of interest.

### Advantageous Effects

According to an aspect of the present disclosure, the battery management apparatus may estimate the degree of battery degradation based on the capacity of interest corresponding to each voltage of interest by differently determining the voltage of interest used to estimate the degree of battery degradation according to the shape of the differential profile.

In addition, according to an aspect of the present disclosure, the battery management apparatus may prevent battery degradation or accelerated degradation by setting the usage conditions of the battery according to the degree of battery degradation.

In addition, according to an aspect of the present disclosure, the battery management apparatus may quickly compare the relative degree of degradation between the plurality of batteries in the battery module or battery pack. In addition, by setting the usage conditions of the plurality of batteries based on the relative degree of degradation, it may be possible to reduce the level of deviation of the degree of degradation between the plurality of batteries.

The effects of the present disclosure are not limited to the aforementioned effects, and these and other effects will be clearly understood by those skilled in the art from the appended claims.

### BRIEF DESCRIPTION OF THE DRAWINGS

The accompanying drawings serve to provide a better understanding of the technical aspect of the present disclosure together with the following detailed description, and thus the present disclosure should not be construed as being limited to the drawings.
FIG. 1 is a diagram schematically showing a battery management apparatus according to an embodiment of the present disclosure.
FIGS. 2 and 3 are diagrams schematically showing a first differential profile according to an embodiment of the present disclosure.
FIG. 4 is a diagram schematically showing a second differential profile according to another embodiment of the present disclosure.
FIG. 5 is a diagram showing an exemplary configuration of a battery pack according to another embodiment of the present disclosure.
FIG. 6 is a diagram schematically showing a vehicle according to another embodiment of the present disclosure.
FIG. 7 is a diagram schematically showing a battery management method according to another embodiment of the present disclosure.

### BEST MODE

It should be understood that the terms or words used in the specification and the appended claims should not be construed as being limited to general and dictionary meanings, and rather, should be interpreted based on the meanings and concepts corresponding to the technical aspect of the present disclosure on the basis of the principle that the inventor is allowed to define the terms appropriately for the best explanation.

Therefore, the embodiments described herein and the illustrations shown in the drawings are provided to describe the technical aspect of the present disclosure by way of example but not intended to be limiting, so it should be understood that a variety of other equivalents and modifications could have been made thereto at the time the application was filed.

In describing the present disclosure, when it is determined that a certain detailed description of related known elements or functions may make the subject matter of the present disclosure obscure or unclear, the detailed description is omitted.

The terms "first", "second" and the like, are used to distinguish one element from another among various elements, and not intended to limit the elements by the terms.

Unless the context clearly indicates otherwise, the terms "comprise" and "include" when used in this specification, specify the presence of stated elements, but do not preclude the presence or addition of one or more other elements.

In addition, throughout the specification, it will be further understood that when an element is referred to as being "connected to" another element, it may be directly connected to the other element or intervening elements may be present.

Hereafter, the exemplary embodiments of the present disclosure will be described in detail with reference to the accompanying drawings.

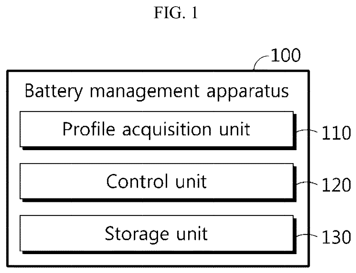

FIG. 1 is a diagram schematically showing a battery management apparatus 100 according to an embodiment of the present disclosure.

Referring to FIG. 1, a battery management apparatus 100 according to an embodiment of the present disclosure may include a profile acquisition unit 110 and a control unit 120.

Here, a battery refers to an independent but physically separable cell having a negative terminal and a positive terminal. For example, a lithium ion battery or a lithium polymer battery may be deemed as the battery. In addition, the type of battery may include a cylindrical type, a prismatic type or a pouch type. In addition, the battery may refer to a battery bank, a battery module or a battery pack including a plurality of cells connected in series and/or in parallel. Hereinafter, for convenience of description, the battery is described as referring to an independent cell.

The profile acquisition unit 110 may be configured to acquire a differential profile indicating a correspondence relationship between voltage and differential capacity of the battery.

Here, the differential capacity indicates an instantaneous change in capacity as a function of voltage. That is, the differential capacity is a value obtained by differentiating capacity with respect to voltage and may be expressed as 'dQ/dV'.

A battery profile is a profile indicating a correspondence relationship between voltage V and capacity Q while the battery is charged from SOC 0% to SOC 100%. Additionally, when differentiating the battery profile with respect to voltage, the differential profile indicating the correspondence relationship between differential capacity dQ/dV and voltage V may be generated. On the contrary, the battery profile may indicate a correspondence relationship between voltage V and capacity Q while the battery is discharged from SOC 100% to SOC 0%.

For example, there is no particular limitation on C-rate in the charge or discharge for generating the battery profile. However, preferably, it is necessary to charge or discharge the battery at a low rate to obtain the battery profile and the differential profile more accurately. For example, the battery profile may be generated during charging or discharging of the battery at 0.05C.

Preferably, the profile acquisition unit 110 may be configured to acquire the differential profile indicating the correspondence relationship between differential capacity and voltage of the battery during charging. For example, the battery profile may be acquired during charging of the battery, and the differential profile may be acquired from the battery profile.

As an example, the profile acquisition unit 110 may directly receive the differential profile of the battery from an external device. That is, the profile acquisition unit 110 may acquire the differential profile of the battery by receiving the differential profile via wired and/or wireless connection to the external device.

As another example, the profile acquisition unit 110 may receive battery information associated with voltage and capacity of the battery. Additionally, the profile acquisition unit 110 may generate the battery profile based on the received battery information, and generate the differential profile based on the generated battery profile. That is, the profile acquisition unit 110 may acquire the differential profile by directly generating the differential profile based on the battery information.

As still another example, the profile acquisition unit 110 may directly measure the voltage and current of the battery. For example, the profile acquisition unit 110 may directly measure the voltage of the battery via direct connection to the positive terminal and the negative terminal of the battery. In addition, the profile acquisition unit 110 may measure the amount of charge and discharge current of the battery, and calculate the capacity of the battery based on the measured amount of current. In addition, the profile acquisition unit 110 may generate the differential profile based on the voltage and capacity of the battery. That is, the profile acquisition unit 110 may acquire the differential profile based on the directly measured voltage and current of the battery.

The profile acquisition unit 110 may be connected to the control unit 120 to enable communication between them. For example, the profile acquisition unit 110 may be connected to the control unit 120 via wire and/or wirelessly. The profile acquisition unit may transmit the acquired differential profile to the control unit 120.

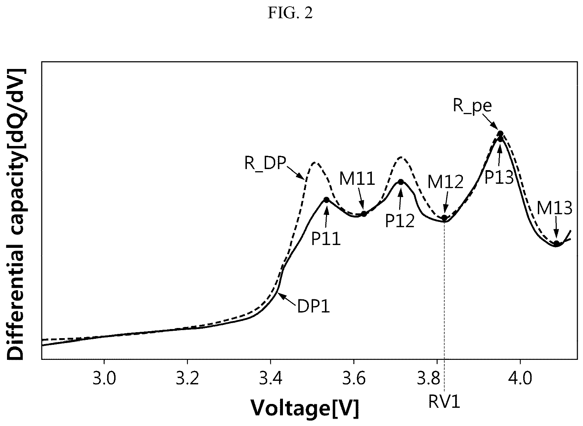

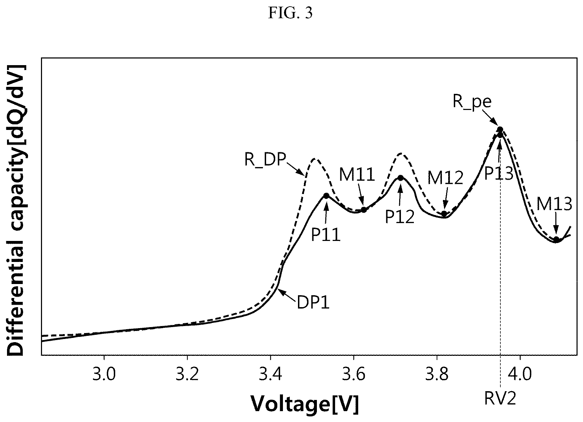

FIGS. 2 and 3 are diagrams schematically showing a first differential profile DP1 according to an embodiment of the present disclosure.

FIG. 2 is a diagram referenced to describe an embodiment of the battery management apparatus 100 according to the present disclosure.

In the embodiment of FIG. 2, the first differential profile DP1 may be represented as a two-dimensional graph in which the X axis is set to voltage V and the Y axis is set to differential capacity dQ/dV.

The control unit 120 may be configured to determine a target peak from among a plurality of peaks included in the differential profile.

Referring to FIG. 2, the first differential profile DP1 may include the plurality of peaks P11, P212, P13.

Here, the peak may refer to a point where the slope (the instantaneous change) of the profile changes from a positive (+) value to a negative (-) value. That is, with respect to the peak, the low voltage side slope is positive, and the high voltage side slope is negative. In other words, the maximum point of the differential profile may be determined as the peak.

Specifically, the target peak may be determined, considering the relative position to other peak in the differential profile. More specifically, the target peak may be determined on the basis of the corresponding voltage.

For example, the control unit 120 may determine the peak having the highest corresponding voltage among the plurality of peaks as the target peak. When only one peak exists in the differential profile, the corresponding peak may be determined as the target peak.

In the embodiment of FIG. 2, the control unit 120 may determine the peak P13 having the highest corresponding voltage among the plurality of peaks P11, P12, P13 as the target peak.

The control unit 120 may be configured to determine the remaining peak except the target peak among the plurality of peaks included in the differential profile as a reference peak.

Specifically, the control unit 120 may determine the peak having the highest corresponding voltage among the plurality of peaks included in the differential profile as the target peak, and determine the remaining peak as the reference peak. In other words, the control unit 120 may determine the peak having lower corresponding voltage than the target peak among the plurality of peaks as the reference peak.

For example, in the embodiment of FIG. 2, the control unit 120 may determine the remaining peaks P11, P12 except the target peak P13 among the plurality of peaks included in the first differential profile DP1 as the reference peak.

The control unit 120 may be configured to compare the differential capacity of the target peak with the differential capacity of the reference peak.

Specifically, the control unit 120 may compare the magnitude of the differential capacity of the target peak with the magnitude of the differential capacity of the reference peak. For example, the control unit 120 may compare the differential capacity of the target peak with the differential capacity of the reference peak to determine which differential capacity is larger or smaller. In the case of a plurality of reference peaks, the control unit 120 may compare the differential capacity of each of the plurality of reference peaks with the differential capacity of the target peak.

For example, in the embodiment of FIG. 2, because of the plurality of reference peaks, the control unit 120 may compare the differential capacity of each of the plurality of reference peaks P11, P12 with the differential capacity of the target peak P13. That is, the control unit 120 may compare the differential capacity of the reference peak P11 with the differential capacity of the target peak P13, and compare the differential capacity of the reference peak P12 with the differential capacity of the target peak P13.

The control unit 120 may be configured to determine a voltage of interest based on the differential capacity comparison result.

Specifically, when the differential capacity of the target peak exceeds the differential capacity of the reference peak, the control unit 120 may determine a preset criterion voltage as the voltage of interest. Here, the criterion voltage may be preset to a voltage that is lower than an end-of-charge voltage set for the battery.

More specifically, the criterion voltage refers to voltage of a criterion battery. Here, the criterion battery may be a reference battery corresponding to the battery or a battery at BOL. However, for convenience of description, the criterion battery is hereinafter described as a battery at BOL. The criterion voltage may be preset based on the shape of a criterion differential profile which is a differential profile obtained from the criterion battery. In other words, the criterion voltage may be preset based on the relationship between voltage and differential capacity of the criterion battery.

For example, the criterion voltage may be preset as voltage of a criterion minimum point having the highest corresponding voltage among a plurality of minimum points included in the criterion differential profile. Preferably, the criterion minimum point may be preset as a minimum point having the highest corresponding voltage on the low voltage side of the criterion peak corresponding to the target peak. Here, the criterion peak may refer to the peak having the highest corresponding voltage among the plurality of peaks included in the criterion differential profile. That is, the target peak is the peak having the highest corresponding voltage among the plurality of peaks included in the differential profile of the battery, and the criterion peak is the peak having the highest corresponding voltage among the plurality of peaks included in the criterion differential profile. Therefore, the criterion peak and the target peak may correspond to each other.

For example, in the embodiment of FIG. 2, the differential capacity of the target peak P13 exceeds the differential capacity of the plurality of reference peaks P11, P12. That is, the differential capacity of the target peak P13 exceeds the differential capacity of the reference peak P11 and exceeds the differential capacity of the reference peak P12. Therefore, the control unit 120 may determine the preset criterion voltage RV1 as the voltage of interest.

Specifically, the voltage of the criterion minimum point which is the minimum point M12 having the highest corresponding voltage on the low voltage side of the criterion peak R_pe corresponding to the target peak P13 among the plurality of minimum points M11, M12, M13 included in the criterion differential profile R_DP may be preset as the criterion voltage RV1. In other words, the voltage of the criterion peak R_pe having the highest corresponding voltage among the plurality of peaks included in the criterion differential profile R_DP is determined, and the minimum point M12 having the highest corresponding voltage among the plurality of minimum points M11, M12 on the low voltage side than the voltage of the criterion peak R_pe in the first differential profile DP1 may be determined as the criterion minimum point. Accordingly, the voltage of the criterion minimum point M12 may be preset as the criterion voltage RV1.

As another example, the criterion voltage may be preset as the voltage of the criterion peak corresponding to the target peak among the plurality of peaks included in the criterion differential profile.

FIG. 3 is a diagram referenced to describe another embodiment of the battery management apparatus 100 according to the present disclosure.

In the embodiment of FIG. 3, the first differential profile DP1 may be represented as a two-dimensional graph in which the X axis is set to voltage V and the Y axis is set to differential capacity dQ/dV.

The criterion differential profile R_DP and the first differential profile DP1 of FIG. 3 are the same as the criterion differential profile R_DP and the first differential profile DP1 shown in FIG. 2. Accordingly, the target peak P13, the reference peaks P11, P12, and the criterion peak R_pe are determined in the same way as the embodiment of FIG. 2.

For example, in the embodiment of FIG. 3, the differential capacity of the target peak P13 exceeds the differential capacity of the plurality of reference peaks P11, P12. That is, the differential capacity of the target peak P13 exceeds the differential capacity of the reference peak P11 and exceeds the differential capacity of the reference peak P12. Therefore, the control unit 120 may determine the preset criterion voltage RV2 as the voltage of interest.

Specifically, the criterion voltage RV2 may be preset as the voltage of the criterion peak R_pe corresponding to the target peak P13 among the plurality of peaks included in the criterion differential profile R_DP. In other words, the voltage of the peak having the highest corresponding voltage among the plurality of peaks included in the criterion differential profile R_DP may be preset as the criterion voltage RV2.

On the contrary, when the differential capacity of the target peak is equal to or less than the differential capacity of the reference peak, the control unit 120 may determine the end-of-charge voltage set for the battery as the voltage of interest.

In the case of the plurality of reference peaks, the differential capacity of the target peak equal to or less than the differential capacity of the reference peak represents that the differential capacity of the target peak is equal to or less than the differential capacity of at least one of the plurality of reference peaks. In other words, when the differential capacity of at least one reference peak is equal to or larger than the differential capacity of the target peak, it may be thought that the differential capacity of the target peak is equal to or less than the differential capacity of the reference peak.

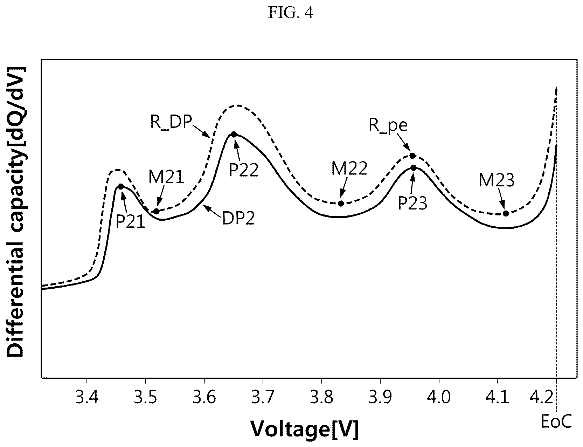

FIG. 4 is a diagram schematically showing a second differential profile DP2 according to another embodiment of the present disclosure.

FIG. 4 is a diagram referenced to describe another embodiment of the battery management apparatus 100 according to the present disclosure.

In the embodiment of FIG. 4, the second differential profile DP2 may be represented as a two-dimensional graph in which the X axis is set to voltage V and the Y axis is set to differential capacity dQ/dV.

The control unit 120 may determine peak P23 having the highest corresponding voltage from among a plurality of peaks P21, P22, P23 included in the second differential profile DP2 as the target peak. In addition, the control unit 120 may determine the remaining peaks P21, P22 except the target peak P23 among the plurality of peaks P21, P22, P23 as the reference peak.

The differential capacity of the target peak P23 exceeds the differential capacity of the reference peak P21, but is equal to or less than the differential capacity of the reference peak P22. That is, the differential capacity of the target peak P23 is equal to or less than the differential capacity of the reference peak. Therefore, the control unit 120 may determine the end-of-charge voltage EoC (for example, 4.2 [V]) set for the battery as the voltage of interest.

The control unit 120 may be configured to estimate the degree of degradation of the battery based on the capacity of interest of the battery corresponding to the voltage of interest.

Specifically, the control unit 120 may calculate the capacity of interest of the battery corresponding to the voltage of interest.

For example, when the voltage of interest is set as the preset criterion voltage, the control unit 120 may calculate the capacity of the battery corresponding to the criterion voltage as the capacity of interest. As another example, when the voltage of interest is set as the end-of-charge voltage, the control unit 120 may calculate the capacity of the battery corresponding to the end-of-charge voltage as the capacity of interest. For example, in the embodiment of FIG. 2, the control unit 120 may calculate the capacity of interest of the battery by integrating the first differential profile DP1 with respect to the voltage up to the criterion voltage RV1. As another example, in the embodiment of FIG. 3, the control unit 120 may calculate the capacity of interest of the battery by integrating the first differential profile DP1 with respect to the voltage up to the criterion voltage RV2. As another example, in the embodiment of FIG. 4, the control unit 120 may calculate the capacity of interest of the battery by integrating the second differential profile DP2 with respect to the voltage up to the end-of-charge voltage EoC.

Additionally, the control unit 120 may estimate the degree of degradation of the battery through comparison between the capacity of interest and the criterion capacity.

Here, the degree of degradation of the battery may refer to a difference between the criterion capacity of the battery and the capacity of interest. Alternatively, the degree of degradation of the battery may refer to a ratio of the capacity of interest to the criterion capacity of the battery. Here, the criterion capacity of the battery is capacity of the criterion battery corresponding to the voltage of interest. For example, when the voltage of interest is the end-of-charge voltage, the criterion capacity may be a full-charge capacity (e.g., total capacity) of the battery at BOL. As another example, when the voltage of interest is the preset criterion voltage, the criterion capacity may be a partial capacity of the battery at BOL corresponding to the criterion voltage. For example, in the embodiment of FIG. 2, the criterion capacity is a value obtained by integrating the criterion differential profile R_DP with respect to voltage up to the criterion voltage RV1. As another example, in the embodiment of FIG. 3, the criterion capacity is a value obtained by integrating the criterion differential profile R_DP with respect to voltage up to the criterion voltage RV2. As another example, in the embodiment of FIG. 4, the criterion capacity is a value obtained by integrating the criterion differential profile R_DP with respect to voltage up to the end-of-charge voltage EoC.

For example, the control unit 120 may estimate the degree of degradation of the battery by calculating the ratio of the capacity of interest to the criterion capacity. Specifically, the control unit 120 may estimate the degree of degradation of the battery by calculating the Equation of "capacity of interest ÷ criterion capacity × 100." In the Equation, because 100 is a constant for including the degree of degradation of the battery in a range of 0(%) to 100(%), it may be omitted.

The battery management apparatus 100 according to an embodiment of the present disclosure may estimate the degree of degradation of the battery based on the capacity of interest corresponding to each voltage of interest by differently determining the voltage of interest used to estimate the degree of degradation of the battery according to the shape of a differential profile.

In general, the degree of degradation of the battery may be estimated through comparison between the criterion capacity and the current capacity on the basis of the point in time when the battery is fully charged. However, when the shape of the differential profile is a specific shape, even though the degree of degradation of the battery is estimated on the basis of the point in time before the battery is fully charged, an error in the estimated degree of degradation may be insignificant. For example, as in the embodiment of FIG. 2, when the voltage of the target peak P13 among the plurality of peaks P11, P12, and P13 is the highest, a capacity difference between the capacity after the criterion voltage RV1 of the criterion differential profile R_DP and the capacity after the criterion voltage RV1 of the first differential profile DP1 may be at negligible level. Therefore, even though the battery is charged to the criterion voltage RV1, the degree of degradation of the battery may be quickly estimated only by comparison of the criterion capacity and the capacity of interest.

Meanwhile, the control unit 120 of the battery management apparatus 100 may selectively include a processor, an application-specific integrated circuit (ASIC), another chipset, a logic circuit, a register, a communication modem or a data processing device, known in the technical field to execute various control logics performed in the present disclosure. In addition, when the control logic is implemented as software, the control unit 120 may be implemented as a set of program modules. In this instance, the program modules may be stored in a memory and executed by the control unit 120. The memory may be inside or outside the control unit 120 and connected to the control unit 120 by a variety of well-known means.

In addition, the battery management apparatus 100 may further include a storage unit 130. The storage unit 130 may store data or programs necessary for each component of the battery management apparatus 100 to perform operations and functions, or data created in the process of performing the operations and functions. The storage unit 130 is not limited to a particular type and may include any information storage means known as being able to record, erase, update and derive data. As an example, the information storage means may include RAM, flash memory, ROM, EEPROM or register. In addition, the storage unit 130 may store program codes defining the processes that may be performed by the control unit 120.

Specifically, the storage unit 130 may store information necessary for the control unit 120 to estimate the degree of degradation of the battery. For example, the storage unit 130 may store the criterion voltage, the differential profile of the battery, the voltage of interest and the capacity of interest. Additionally, the control unit 120 may obtain information necessary for estimating the degree of degradation of the battery by accessing the storage unit 130.

The control unit 120 may be configured to set usage conditions of the battery based on the estimated degree of degradation of the battery.

When the end-of-charge voltage of the battery is determined as the voltage of interest, the control unit 120 may estimate the degree of degradation of the battery based on the full charge capacity. The control unit 120 may set the usage conditions of the battery according to the estimated degree of degradation based on the full charge capacity.

Specifically, the control unit 120 may adjust the upper limit of the charge/discharge rate (C-rate) range of the battery. As an example, the control unit 120 may decrease the upper limit of the charge/discharge rate range of the battery. As another example, the control unit 120 may increase the lower limit of the charge/discharge rate range of the battery. As still another example, the control unit 120 may decrease the upper limit of the charge/discharge rate range of the battery and increase the lower limit of the charge/discharge rate range.

Alternatively, the control unit 120 may adjust the available SOC range of the battery. As an example, the control unit 120 may decrease the upper limit of the available SOC range of the battery. As another example, the control unit 120 may increase the lower limit of the available SOC range of the battery. As still another example, the control unit 120 may decrease the upper limit of the available SOC range of the battery and increase the lower limit of the available SOC range.

That is, the battery management apparatus 100 according to an embodiment of the present disclosure may prevent battery degradation or accelerated degradation through the adjustment of the charge/discharge rate range or the available SOC range according to the degree of degradation of the battery.

In addition, when the criterion voltage is determined as the voltage of interest, the control unit 120 may estimate the degree of degradation of the battery based on the capacity of interest. In this case, when the battery is only charged up to the criterion voltage, the degree of degradation of the battery may be quickly estimated. The degree of degradation estimated based on the criterion voltage is an approximate value of the degree of degradation estimated based on the end-of-charge voltage, and may be used to compare the relative degree of degradation between the plurality of batteries in the battery module or battery pack. The control unit 120 may set the usage conditions of the plurality of batteries based on the relative degree of degradation between the plurality of batteries. As an example, the control unit 120 may either decrease the upper limit of the charge/discharge rate range of the battery having a large relative degree of degradation among the plurality of batteries, or increase the lower limit of the charge/discharge rate range, or both. As another example, the control unit 120 may either increase the upper limit of the charge/discharge rate range of the battery having a small relative degree of degradation among the plurality of batteries, or increase the lower limit of the charge/discharge rate range, or both.

That is, the battery management apparatus 100 according to an embodiment of the present disclosure may quickly compare the relative degree of degradation between the plurality of batteries in the battery module or battery pack. In addition, by setting the usage conditions of the plurality of batteries based on the relative degree of degradation, it may be possible to reduce the level of deviation of the degree of degradation between the plurality of batteries.

The battery management apparatus 100 according to the present disclosure may be applied to a Battery Management System (BMS). That is, the BMS according to the present disclosure may include the battery management apparatus 100. In this configuration, at least some of the components of the battery management apparatus 100 may be implemented by supplementing or adding the functions of the components generally included in the BMS. For example, the profile acquisition unit 110, the control unit 120 and the storage unit 130 of the battery management apparatus 100 may be implemented as the components of the BMS.

In addition, the battery management apparatus 100 according to the present disclosure may be equipped in a battery pack. That is, the battery pack according to the present disclosure may include the battery management apparatus 100 and at least one battery cell. In addition, the battery pack may further include electrical components (relay, fuse) and a case.

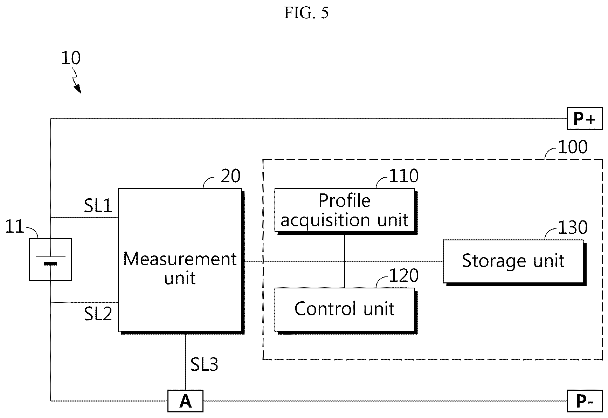

FIG. 5 is a diagram showing the exemplary configuration of the battery pack according to another embodiment of the present disclosure.

A positive terminal of the battery 11 may be connected to a positive terminal (P+) of the battery pack 10, and a negative terminal of the battery 11 may be connected to a negative terminal (P-) of the battery pack 10.

The measurement unit 20 may be connected to a first sensing line SL1, a second sensing line SL2 and a third sensing line SL3. Specifically, the measurement unit 20 may be connected to the positive terminal of the battery 11 through the first sensing line SL1, and the negative terminal of the battery 11 through the second sensing line SL2. The measurement unit 20 may measure the voltage of the battery 11 based on the voltage measured at each of the first sensing line SL1 and the second sensing line SL2.

Additionally, the measurement unit 20 may be connected to a current measurement unit A through the third sensing line SL3. For example, the current measurement unit A may be an ammeter or a shunt resistor for measuring the charging current and the discharging current of the battery 11. The measurement unit 20 may measure the charging current of the battery 11 through the third sensing line SL3 and calculate the charging amount. In addition, the measurement unit 20 may measure the discharging current of the battery 11 through the third sensing line SL3 and calculate the discharging amount.

An external device (not shown) may be, at one end, connected to the positive terminal (P+) of the battery pack 10 and at the other end, connected to the negative terminal (P-) of the battery pack 10. Accordingly, the positive terminal of the battery 11, the positive terminal (P+) of the battery pack 10, the external device, the negative terminal (P-) of the battery pack 10, and the negative terminal of the battery 11 may be electrically connected.

For example, the external device may be a charger, or a load such as a motor of an electric vehicle that is supplied with power from the battery 11.

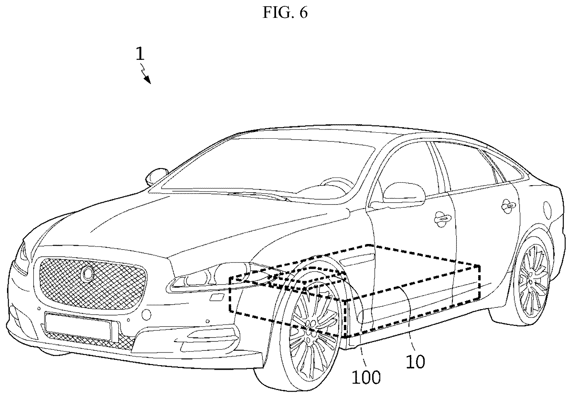

FIG. 6 schematically showing a vehicle 1 according to another embodiment of the present disclosure.

Referring to FIG. 6, the battery pack 10 according to an embodiment of the present disclosure may be included in the vehicle 1, such as an electric vehicle (EV) or a hybrid electric vehicle (HV). Here, as the battery pack 10, the above-described battery pack 10 may be applied. In addition, the battery pack 10 may drive the vehicle 1 by supplying power to the motor through an inverter of the vehicle 1. Here, the battery pack 10 may include the battery management apparatus 100 according to an embodiment of the present disclosure. That is, the vehicle 1 may include the battery management apparatus 100.

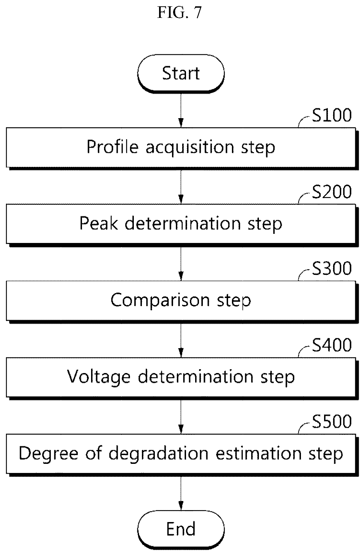

FIG. 7 is a diagram schematically showing a battery management method according to another embodiment of the present disclosure.

Referring to FIG. 7, the battery management method may include a profile acquisition step (S100), a peak determination step (S200), a comparison step (S300), a voltage determination step (S400) and a degree of degradation estimation step (S500).

Preferably, each step of the battery management method may be performed by the battery management apparatus 100. Hereinafter, for convenience of description, the shared description with the foregoing description is omitted or will be briefly described.

The profile acquisition step (S100) is a step of acquiring the differential profile indicating the correspondence relationship between voltage and differential capacity of the battery, and may be performed by the profile acquisition unit 110.

The peak determination step (S200) is a step of determining the target peak from among the plurality of peaks included in the differential profile and determining the remaining peak except the target peak among the plurality of peaks as the reference peak, and may be performed by the control unit 120.

For example, the control unit 120 may determine the peak having the highest corresponding voltage among the plurality of peaks included in the differential profile as the target peak.

For example, in the embodiment of FIG. 2, the control unit 120 may determine the peak P13 having the highest corresponding voltage among the plurality of peaks P11, P12, P13 included in the first differential profile DP1 as the target peak, and determine the remaining peaks P11, P12 as the reference peak.

The comparison step (S300) is a step of comparing the differential capacity of the target peak with the differential capacity of the reference peak, and may be performed by the control unit 120.

Specifically, the control unit 120 may compare the differential capacity of the target peak with the differential capacity of the reference peak to determine which differential capacity is larger.

For example, in the embodiment of FIG. 2, the control unit 120 may compare the differential capacity of the target peak P13 with the differential capacity of the plurality of reference peaks P11, P12 to determine which differential capacity is larger.

The voltage determination step (S400) is a step of determining the voltage of interest based on the differential capacity comparison result, and may be performed by the control unit 120.

Specifically, the control unit 120 may determine the criterion voltage as the voltage of interest when the differential capacity of the target peak exceeds the differential capacity of the reference peak. On the contrary, the control unit 120 may determine the end-of-charge voltage set for the battery as the voltage of interest when the differential capacity of the target peak is equal to or less than the differential capacity of the reference peak. Here, the criterion voltage may be preset to a lower voltage than the end-of-charge voltage set for the battery.

More specifically, the criterion voltage refers to voltage of the criterion battery. Here, the criterion battery may be a reference battery corresponding to the battery or a battery at BOL. The criterion differential profile is a differential profile obtained from the criterion battery.

For example, the criterion voltage may be preset as voltage of the criterion minimum point having the highest corresponding voltage among the plurality of minimum points included in the criterion differential profile. Preferably, the criterion minimum point may be preset as a minimum point having the highest corresponding voltage on the low voltage side of the criterion peak corresponding to the target peak. Here, the criterion peak may refer to the peak having the highest corresponding voltage among the plurality of peaks included in the criterion differential profile.

For example, in the embodiment of FIG. 2, the differential capacity of the target peak P13 exceeds the differential capacity of each of the plurality of reference peaks P11, P12. Therefore, the control unit 120 may determine the preset criterion voltage RV1 as the voltage of interest. Here, the criterion voltage RV1 may be preset as voltage of the criterion minimum point M12 having the highest corresponding voltage on the low voltage side of the criterion peak R_pe corresponding to the target peak P13 among the plurality of minimum points M11, M12, M13 included in the criterion differential profile R_DP.

The degree of degradation estimation step (S500) is a step of estimating the degree of degradation of the battery based on the capacity of interest of the battery corresponding to the voltage of interest, and may be performed by the control unit 120.

Specifically, the control unit 120 may calculate the capacity of interest of the battery corresponding to the voltage of interest. Additionally, the control unit 120 may estimate the degree of degradation of the battery through comparison between the capacity of interest and the criterion capacity. Here, the degree of degradation of the battery may refer to a difference between the criterion capacity of the battery and the capacity of interest. Alternatively, the degree of degradation of the battery may refer to a ratio of the capacity of interest to the criterion capacity of the battery. Here, the criterion capacity of the battery is capacity of the criterion battery corresponding to the voltage of interest.

For example, in the embodiment of FIG. 2, the control unit 120 may calculate the capacity of interest of the battery by integrating the first differential profile DP1 with respect to voltage up to the criterion voltage RV1. The criterion capacity is a value obtained by integrating the criterion differential profile R_DP with respect to voltage up to the criterion voltage RV. The control unit 120 may estimate the degree of degradation of the battery by comparing the capacity of interest and the criterion capacity obtained by integrating the first differential profile DP1 and the criterion differential profile D_DP up to the criterion voltage RV1.

The embodiments of the present disclosure as described herein are not embodied only through the apparatus and method, and may be implemented through programs that perform the functions corresponding to the exemplary configurations of the present disclosure or recording media having the programs recorded thereon, and such implementation may be easily achieved by those skilled in the art from the disclosure of the embodiments previously described.

Although the present disclosure has been hereinabove described with regard to a limited number of embodiments and drawings, the present disclosure is not limited thereto and it is obvious to those skilled in the art that various modifications and changes may be made thereto within the technical aspect of the present disclosure and the scope of the appended claims and their equivalents.

Additionally, as many substitutions, modifications and changes may be made to the present disclosure as described above by those skilled in the art without departing from the technical aspect of the present disclosure, the present disclosure is not limited by the above-described embodiments and the accompanying drawings, and some or all of the embodiments may be selectively combined to allow various modifications.

### [List of Reference Numerals]

1: Vehicle
10: Battery pack
100: Battery management apparatus
110: Profile acquisition unit
120: Control Unit
130: Storage unit

## Claims

1. A battery management apparatus comprising:
a profile acquisition unit configured to acquire a differential profile indicating a correspondence relationship between voltage and differential capacity of a battery; and
a control unit configured to determine a target peak from among a plurality of peaks included in the differential profile, determine the remaining peak except the target peak among the plurality of peaks as a reference peak, compare a differential capacity of the target peak with a differential capacity of the reference peak, determine a voltage of interest based on a result of the differential capacity comparison, and estimate a degree of degradation of the battery based on a capacity of interest of the battery corresponding to the voltage of interest.

2. The battery management apparatus according to claim 1,
wherein the control unit is configured to:
determine the peak having highest corresponding voltage among the plurality of peaks as the target peak.

3. The battery management apparatus according to claim 1,
wherein the control unit is configured to:
determine a preset criterion voltage as the voltage of interest when the differential capacity of the target peak exceeds the differential capacity of the reference peak.

4. The battery management apparatus according to claim 3,
wherein the criterion voltage is preset as a voltage of a criterion minimum point having highest corresponding voltage among a plurality of minimum points included in a preset criterion differential profile corresponding to the battery.

5. The battery management apparatus according to claim 4,
wherein the criterion minimum point is preset as a minimum point having highest corresponding voltage on a low voltage side of a criterion peak corresponding to the target peak.

6. The battery management apparatus according to claim 4,
wherein the criterion voltage is preset as a voltage of a criterion peak corresponding to the target peak among the plurality of peaks included in the criterion differential profile.

7. The battery management apparatus according to claim 1,
wherein the control unit is configured to:
determine an end-of-charge voltage of the battery as the voltage of interest when the differential capacity of the target peak is equal to or less than the differential capacity of the reference peak.

8. The battery management apparatus according to claim 1,
wherein the control unit is configured to:
estimate a difference between a preset criterion capacity and the capacity of interest as the degree of degradation of the battery, and
wherein the criterion capacity is a preset capacity corresponding to the voltage of interest.

9. The battery management apparatus according to claim 1,
wherein the control unit is configured to:
estimate a ratio of the capacity of interest to a preset criterion capacity as the degree of degradation of the battery, and
wherein the criterion capacity is a preset capacity corresponding to the voltage of interest.

10. The battery management apparatus according to claim 1,
wherein the control unit is configured to:
set usage conditions of the battery based on the estimated degree of degradation of the battery.

11. A battery pack comprising the battery management apparatus according to any one of claims 1 to 10.

12. A vehicle comprising the battery management apparatus according to any one of claims 1 to 10.

13. A battery management method comprising:
a profile acquisition step of acquiring a differential profile indicating a correspondence relationship between voltage and differential capacity of a battery;
a peak determination step of determining a target peak from among a plurality of peaks included in the differential profile, and determining the remaining peak except the target peak among the plurality of peaks as a reference peak;
a comparison step of comparing a differential capacity of the target peak with a differential capacity of the reference peak;
a voltage determination step of determining a voltage of interest based on a result of the differential capacity comparison; and
a degree of degradation estimation step of estimating a degree of degradation of the battery based on a capacity of interest of the battery corresponding to the voltage of interest.
